# EUROPÄISCHE PATENTSCHRIFT

(11) **EP 0 960 422 B1**
(45) Veröffentlichungstag und Bekanntmachung des Hinweises auf die Patenterteilung: **21.11.2001**
(21) Anmeldenummer: 98909316.6
(22) Anmeldetag: 02.02.1998
(51) Int. Cl.: G11C 11/407, G11C 29/00

(54) **VERFAHREN ZUR MINIMIERUNG DER ZUGRIFFSZEIT BEI HALBLEITERSPEICHERN**
METHOD FOR MINIMIZING THE ACCESS TIME FOR SEMICONDUCTOR MEMORIES
PROCEDE POUR MINIMISER LE TEMPS D'ACCES POUR DES MEMOIRES A SEMICONDUCTEUR

(30) Priorität: 12.02.1997 DE 19705355
(43) Veröffentlichungstag der Anmeldung: 01.12.1999
(73) Patentinhaber: Infineon Technologies AG, 81669 München (DE)
(72) Erfinder: BEER, Leopold, D-71065 Sindelfingen (DE)
(74) Vertreter: Zedlitz, Peter, Dipl.-Inf.
(86) Internationale Anmeldenummer: DE9800290
(87) Internationale Veröffentlichungsnummer: WO9836418

(56) Entgegenhaltungen:
- EP-A- 0 602 355
- US-A- 4 631 724
- SHIGERU ATSUMI, SUMIO TANAKA, KAZUYOSHI SHINADA, KUNIYOSHI YOSHIKAWA, KOHJI MAKITA, YOSHIDE NAGAKUBO, KOICHI KANZAKI: "FAST PROGRAMMABLE 256K READ ONLY MEMORY WITH ON-CHIP TEST CIRCUITS" IEEE TRANSACTIONS ON ELECTRON DEVICES., Bd. ED-32, Nr. 2, Februar 1985, NEW YORK US, Seiten 502-507, XP002069899
- BIROLINI A ET AL: "TEST AND SCREENING STRATEGIES FOR LARGE MEMORIES" PROCEEDINGS OF THE EUROPEAN TEST CONFERENCE, PARIS, APRIL 12 - 14, 1989, Nr. CONF. 1, 12.April 1989, INSTITUTE OF ELECTRICAL AND ELECTRONICS ENGINEERS, Seiten 276-283, XP000044392
- PRAVEEN GRUPTA : "BACK-BIAS TESTING IN DRAMS" ELECTRONIC ENGINEERING., Bd. 57, Nr. 707, November 1985, LONDON GB, Seite 185,188,190,193 XP002069900

## Beschreibung

Die Erfindung betrifft ein Verfahren für Halbleiterspeicher zur Minimierung der Zugriffszeit.

Halbleiterspeicher wie z.B. dynamische Halbleiterspeicher (DRAMs) werden aus Halbleiterscheiben (Wafer) gefertigt. Ein Wafer enthält eine Vielzahl gleicher Speicherchips. Herstellungsbedingt streuen die elektrischen Parameter dieser einzelnen Chips.

Ein wichtiges Kriterium für die Leistungsbeurteilung und die Auswahl von dynamischen Halbleiterspeichern unter den elektrischen Parametern ist die Zugriffszeit. Die Zugriffszeit ist die Zeit, die bei einem Lesevorgang nach dem Anlegen der Adresse verstreicht, bis die ausgelesenen Daten am Ausgang gültig sind. Sie wird vom Design und von einer Vielzahl von technologischen Parametern (Poly2-Ätzmaß, Gateoxid, Spacer-Teos,...) bestimmt.
Aufgrund von Toleranzen der technologischen Parameter und fertigungsbedingt variieren die Zugriffszeiten sowohl bei Speicherchips eines einzelnen Wafers untereinander, als auch bei Speicherchips verschiedener Wafer einer Fertigungsserie. Bei einer zufälligen Auswahl von Speicherchips sind die Zugriffszeiten normalverteilt. Der Anteil an Speicherchips, deren Zugriffszeit über einer bestimmten Grenze liegt, kann nur zu einem geringerem Preis verkauft werden als die schnelleren Speicherchips, also die Speicherchips, die eine kleinere Zugriffszeit aufweisen.
Werden die technologischen Parameter so gewählt, dass der Anteil schneller Chips sich erhöht, so steigt auch der Anteil defekter Speicherchips z. B. als Folge des Punch-through-Effekts bei Transistoren oder sonstiger herstellungsbedingter Störungen.

Die EP 0 602 355 A1 offenbart einen Spannungsgenerator für Speicher und Schaltkreise, der mit Fuses programmierbar ist. Eine interne Spannung wird schrittweise mit einem Zähler auf eine gewünschte Spannung erhöht und durch Trennen der Fuses fest eingestellt. Die Ansprüche sind gegen dieses Dokument abgegrenzt.

Aus Atsumi et. al., "Fast Programmable 256K Read Only Memory with On-Chip Test Circuits", in: IEEE Transactions on Electron Devices (ED 32,2/1985, No. 2, NY, USA) ist der Zusammenhang zwischen der Versorgungsspannung und der Zugriffszeit eines Halbleiterspeichers bekannt.

Der Erfindung liegt die Aufgabe zugrunde, die Zugriffszeit von Halbleiterspeichern zu minimieren, die aufgrund technologischer Parameterschwankungen eine größere Zugriffszeit aufweisen, als die bei den gewählten technologischen Parametern erreichbare Zugrffszeit.

Diese Aufgabe wird bei dem Verfahren der eingangs genannten Art durch die Merkmale der Patentansprüche 1 und 2 gelöst.

Die Erfindung hat den Vorteil, dass die Ausbeute an verhältnismäßig schnellen Speicherchips, gemessen an der Gesamtheit aller Speicherchips auf einem Wafer und der Gesamtheit aller Speicherchips einer Fertigungsserie im Vergleich zu Speichern, bei denen das erfindungsgemäße Verfahren nicht benutzt wird, erhöht wird. Die Anwendung des Verfahrens beeinträchtigt nicht die Ausbeute an funktionsfähigen Speicherchips. Ein weiterer Vorteil des erfindungsgemäßen Verfahrens liegt darin, dass Fertigungsschwankungen, die sich auf die Zugriffszeit auswirken, nach der Produktion kompensiert werden. Zudem lassen sich die technologischen Parameter, insbesondere die Poly2-Linienbreite, so dimensionieren, dass sie innerhalb eines sicheren Bereichs liegen, in dem technologiebedingte Ausfälle vermieden werden.

Ausgestaltungen der Erfindung sind in den Unteransprüchen gekennzeichnet.

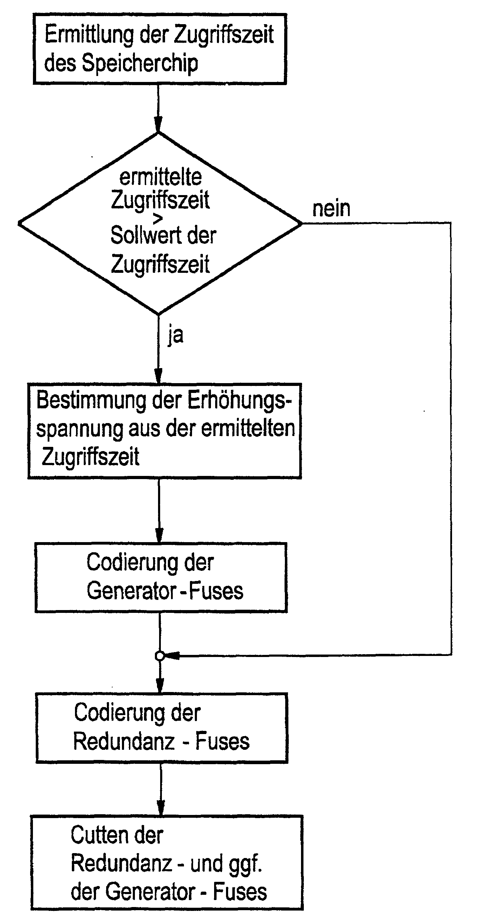

Die Erfindung wird nachfolgend in Verbindung mit dem in der Figur dargestellten Ausführungsbeispiel näher erläutert. Die Figur zeigt einen möglichen Ablauf des erfindungsgemäßen Verfahrens.

Bei vorgegebenem Design und technologischen Parametern hängt die Zugriffszeit maßgeblich von der internen Versorgungsspannung, bei der das Zellenfeld des Halbleiterspeichers arbeitet, ab. Diese kann von einer externen Versorgungsspannung, mit der die außerhalb der Zellenfelder liegende äußere Schaltung betrieben wird, abweichen.
Die vorliegende Erfindung geht davon aus, dass ein Versorgungsspannungsgenerator auf dem Speicherchip die interne Versorgungsspannung zur Verfügung stellt. Das erfindungsgemäße Verfahren lässt sich jedoch auch ohne weiteres einsetzen, wenn die interne Versorgungsspannung von einem Versorgungsspannungsgenerator auf einem eigenem Chip untergebracht ist oder dem Halbleiterspeicher in einer anderen Weise von außen zugeführt wird.
Die interne Versorgungspannung hat direkten Einfluss auf die Zugriffszeit. Durch ihre Erhöhung wird die Stromergiebigkeit und Steilheit der Transistoren des Zellenfeldes des Speichers erhöht. Das führt zu einem schnelleren Schaltverhalten der Transistoren und somit zu einer kürzeren Zugriffszeit. Die interne Versorgungsspannung ist üblicherweise konstant (z. B. 3,3V). Das erfindungsgemäße Verfahren sieht vor, dass bei den Speicherchips, deren Zugriffszeit eine vorgegebene Schwelle übersteigt, die interne Versorgungsspannung erhöht wird. Dadurch verringert sich die Zugriffszeit.

In einem ersten Schritt des Verfahrens wird der Wert von einem Parameter, der ein eindeutiges Maß für die Zugriffszeit des Halbleiterchips ist, bestimmt. Aus dem Wert dieses die Zugriffszeit charakterisierenden Parameters lässt sich z. B. mathematisch oder mit Hilfe einer vorhandenen Messkurve die Zugriffszeit ermitteln. Der Parameter kann z. B. der Standby-Strom sein, also der Versorgungsstrom, der bei inaktiviertem Halbleiterspeicher fließt, wenn kein Zugriff auf den Halbleiterspeicher erfolgt. Der Standby-Strom lässt sich beispielsweise innerhalb einer ersten durchgeführten Testprozedur (Pre-Die-Sort), wenn sich die einzelnen Halbleiterchips noch auf dem Wafer befinden, messen.
Vorzugsweise wird der Standby-Strom während einer Initialisierungsphase zu einem Zeitpunkt nach Anlegen der externen Versorgungsspannung an den Halbleiterspeicher, zu dem der Halbleiterspeicher gerade seinen funktionsbereiten Zustand erreicht hat, ermittelt.
Die sich ergebende Differenz aus einem Sollwert der Zugriffszeit, der mit der vorgegebenen Schwelle der Zugriffszeit identisch ist oder darüber liegt, und der ermittelten Zugriffszeit bestimmt den Betrag der Spannung, auf den die interne Versorgungsspannung anschließend angehoben wird. Bei dieser Erhöhungsspannung ist die Zugriffszeit kleiner als zuvor. Sie wird jeweils in Abhängigkeit von dem Wert des gemessenen die Zugriffszeit charakterisierenden Parameters so festgelegt, dass sie betragsmäßig möglichst hoch ist, die Funktionstüchtigkeit des Halbleiterspeichers jedoch erhalten bleibt.
Es ist durchaus im Sinne der Erfindung, von dem Wert des gemessenen charakteristischen Parameters direkt auf die mögliche Erhöhungsspannung zu schließen. Dazu dienen z. B. in Testläufen bestimmte Messkurven, die den Zusammenhang zwischen dem ermittelten Wert des die Zugriffszeit charakterisierenden Parameters und der maximal zulässigen internen Versorgungsspannung (=Erhöhungsspannung) wiedergeben.

Wie dem Fachmann bekannt ist, werden bei Halbleiterspeichern redundante Speicherzellen, die zum Ersatz defekter Speicherzellen vorgesehen sind, ausgewählt, indem sogenannte Redundanz-Fuses durchtrennt werden (Cutten von Redundanz-Fuses). Die Einstellung der Spannung bei Versorgungsspannungsgeneratoren geschieht häufig in ähnlicher Weise über Generator-Fuses. Bei einer besonderen Ausführungsform des erfindungsgemäßen Verfahrens werden in Abhängigkeit von der ermittelten Erhöhungsspannung geeignete Generator-Fuses durchtrennt. Dies kann zeitlich parallel zum Durchtrennen eventuell vorhandener Redundanz-Fuses geschehen.
Die interne Versorgungsspannung wird also bei dieser Ausführungsform mit dem Durchtrennen einzelner Generator-Fuses stufenweise erhöht. Vorteilhaft ist es, eine Erhöhung in Stufen zu 0,3 V vorzusehen. Dabei ist es günstig, wenn insgesamt eine Spannungsänderung von über 1 V erreicht werden kann. Es sind jedoch auch andere Spannungsstufen und andere Spannungsänderungen möglich.

Das Durchtrennen der Generator-Fuses geschieht üblicherweise mittels Laserlicht oder mit Stromimpulsen.

Als die Zugriffszeit charakterisierender Parameter kann alternativ auch die Einsatzspannung eines Feldeffekttransistors vorgesehen werden. Befindet sich dieser ebenfalls auf dem Halbleiterspeicher, so ist er den gleichen Fertigungsschwankungen unterworfen wie der eigentliche Halbleiterspeicher. Es besteht also ein direkter Zusammenhang zwischen der Einsatzspannung des Feldeffekttransistors und der Zugriffszeit des Halbleiterspeichers, der dazu verwendet wird, die interne Versorgungsspannung auf den Wert der Erhöhungsspannung einzustellen. Die Einsatzspannung wird dazu beispielsweise einer Steuerschaltung übergeben, die den Versorgungsspannungsgenerator unmittelbar steuert.

Das Flussdiagrammm in der Figur zeigt eine Ausführungsform des erfindungsgemäßen Verfahrens innerhalb eines Fertigungsablaufs. Die Zugriffszeit der Speicherchips wird, z. B. während eines ersten Funktionstests der Speicherchips, ermittelt. Durch einen Vergleich der ermittelten Zugriffszeit mit dem vorgegebenen Sollwert werden die Speicherchips herausgefunden, die zu langsam sind und bei denen somit die interne Versorgungspannung erhöht wird. Ihre Erhöhungsspannung wird ausgehend von der ermittelten Zugriffszeit bestimmt.
Die räumliche Position auf der Waferebene eines jeden Speicherchips ist durch seine Koordinaten bestimmt. Für jeden Speicherchip wird auf einem Datenträger zusammen mit seiner Position festgehalten, ob sich eine und gegebenenfalls welche Erhöhungsspannung aus der gemessenen Zugriffszeit ergibt. Diese Angaben werden beim Durchtrennen der Generator-Fuses benötigt und dienen zur Codierung der Generator-Fuses. Anschließend wird für jeden Halbleiterchip auf dem Datenträger zusätzlich festgehalten, welche Redundanz-Fuses zu durchtrennen sind. Diese Codierung der Redundanz-Fuses kann auch vor der Codierung der Generator-Fuses erfolgen.
Die Redundanz- und Generator-Fuses, die in der Codierung der Redundanz-Fuses sowie der Codierung der Generator-Fuses entsprechend gekennzeichnet sind, werden danach durchtrennt. Vorteilhafterweise geschieht dies zusammen in einem einzigen Schritt.
Daran schließen sich die bei Halbleiterchips üblichen Testverfahren an.

## Patentansprüche

1. Verfahren zur Minimierung der Zugriffszeit auf Daten eines Halbleiterspeichers mittels eines Versorgungsspannungsgenerators zur Erzeugung einer internen Versorgungsspannung, das mit folgenden Verfahrensschritten ausgerührt wird:
- in Abhängigkeit von einem gegebenen Wert der internen Versorgungsspannung wird der Wert eines die Zugriffszeit charakterisierenden Parameters ermittelt,
- dem ermittelten Wert des Parameters wird der Wert einer Erhöhungsspannung zugeordnet, der betragsmäßig über dem gegebenen Wert der internen Versorgungsspannung des Halbleiterspeichers liegt und bei dem der Speicher gerade noch funktionsgerecht arbeitet,
- die interne Versorgungsspannung wird auf den Wert der Erhöhungsspannung eingestellt, **dadurch gekennzeichnet, dass** als die Zugriffszeit charakterisierender Parameter der Standby-Strom des Halbleiterspeichers benutzt wird.

2. Verfahren zur Minimierung der Zugriffszeit auf Daten eines Halbleiterspeichers mittels eines Versorgungsspannungsgenerators zur Erzeugung einer internen Versorgungsspannung, das mit folgenden Verfahrensschritten ausgeführt wird:
- in Abhängigkeit von einem gegebenen Wert der internen Versorgungsspannung wird der Wert eines die Zugriffszeit charakterisierenden Parameters ermittelt,
- dem ermittelten Wert des Parameters wird der Wert einer Erhöhungsspannung zugeordnet, der betragsmäßig über dem gegebenen Wert der internen Versorgungsspannung des Halbleiterspeichers liegt und bei dem der Speicher gerade noch funktionsgerecht arbeitet,
- die interne Versorgungsspannung wird auf den Wert der Erhöhungsspannung eingestellt, **dadurch gekennzeichnet, dass** als die Zugriffszeit charakterisierender Parameter die Einsatzspannung eines auf dem Halbleiterspeicher befindlichen Feldeffekttransistors benutzt wird.

3. Verfahren nach einem der Ansprüche 1 oder 2, **dadurch gekennzeichnet, dass** der Wert des die Zugriffszeit charakterisierenden Parameters nach Anlegen einer externen Versorgungsspannung an den Halbleiterspeicher ermittelt wird, sobald der Halbleiterspeicher seinen funktionsbereiten Zustand erreicht hat.

4. Verfahren nach einem der Ansprüche 1 oder 2, **dadurch gekennzeichnet, dass** der Wert des die Zugriffszeit charakterisierenden Parameters während eines Funktionstests des Halbleiterspeichers ermittelt wird.

5. Verfahren nach einem der Ansprüche 1 oder 2, **dadurch gekennzeichnet, dass** die Zuordnung des Wertes der Erhöhungsspannung zu dem Wert des ermittelten Parameters mittels experimentell bestimmter Messkurven erfolgt.

6. Verfahren nach einem der Ansprüche 1 oder 2, **dadurch gekennzeichnet, dass** die Einstellung der internen Versorgungsspannung auf den Wert der Erhöhungsspannung durch Durchtrennen wenigstens einer Fuse des Versorgungsspannungsgenerators erfolgt.

7. Verfahren nach Anspruch 2, **dadurch gekennzeichnet, dass** die Einstellung der internen Versorgungsspannung auf den Wert der Erhöhungsspannung durch Steuerung des Versorgungsspannungsgenerators mittels einer Steuerschaltung, der die Einsatzspannung des Feldeffekttransistors übergeben wird, erfolgt.

8. Verfahren nach Anspruch 6, **dadurch gekennzeichnet, dass** das Durchtrennen der Fuse zeitlich parallel zum Durchtrennen etwaiger sonstiger Fuses des Halbleiterspeichers erfolgt.

9. Verfahren nach einem der Ansprüche 1 oder 2, **dadurch gekennzeichnet, dass** das Einstellen der internen Versorgungsspannung auf den Wert der Erhöhungsspannung stufenweise erfolgt.

10. Verfahren nach Anspruch 9, **dadurch gekennzeichnet, dass** das Einstellen in Stufen zu 0,3 V erfolgt.

## Claims

1. Method for minimizing the access time to data in a semiconductor memory by means of a supply voltage generator for producing an internal supply voltage, which method comprises the following method steps:
- the value of a parameter which characterizes the access time is determined as a function of a given value of the internal supply voltage,
- the value determined for the parameter is associated with the value of an increased voltage whose magnitude is greater than the given value of the internal supply voltage of the semiconductor memory and at which the memory just still operates correctly,
- the internal supply voltage is set to the value of the increased voltage, **characterized in that** the standby current of the semiconductor memory is used as the parameter which characterizes the access time.

2. Method for minimizing the access time to data in a semiconductor memory by means of a supply voltage generator for producing an internal supply voltage, which method comprises the following method steps:
- the value of a parameter which characterizes the access time is determined as a function of a given value of the internal supply voltage,
- the value determined for the parameter is associated with the value of an increased voltage whose magnitude is greater than the given value of the internal supply voltage of the semiconductor memory and at which the memory just still operates correctly,
- the internal supply voltage is set to the value of the increased voltage, **characterized in that** the threshold voltage of a field-effect transistor located on the semiconductor memory is used as the parameter which characterizes the access time.

3. Method according to one of Claims 1 or 2, **characterized in that** the value of the parameter which characterizes the access time is determined after application of an external supply voltage to the semiconductor memory and as soon as the semiconductor memory has reached its functional state.

4. Method according to one of Claims 1 or 2, **characterized in that** the value of the parameter which characterizes the access time is determined during a functional test of the semiconductor memory.

5. Method according to one of Claims 1 or 2, **characterized in that** the value of the increased voltage is associated with the value of the determined parameter by means of experimentally derived measurement curves.

6. Method according to one of Claims 1 or 2, **characterized in that** the internal supply voltage is set to the value of the increased voltage by blowing at least one fuse in the supply voltage generator.

7. Method according to Claim 2, **characterized in that** the internal supply voltage is set to the value of the increased voltage by controlling the supply voltage generator by means of a control circuit to which the threshold voltage of the field-effect transistor is passed.

8. Method according to Claim 6, **characterized in that** the fuse is blown in parallel at the same time that any other fuses in the semiconductor memory are blown.

9. Method according to one of Claims 1 or 2, **characterized in that** the internal supply voltage is continuously variably set to the value of the increased voltage.

10. Method according to Claim 9, **characterized in that** the setting process takes place in steps of 0.3 V.

## Revendications

1. Procédé pour minimiser le temps d'accès à des données d'une mémoire à semiconducteur au moyen d'un générateur de tension d'alimentation servant à produire une tension interne d'alimentation, qui est réalisé par les étapes opératoires suivantes :
- en fonction d'une valeur donnée de la tension interne d'alimentation, on détermine la valeur d'un paramètre caractérisant le temps d'accès,
- on associe à la valeur déterminée du paramètre la valeur d'une tension plus élevée, qui est en valeur absolue supérieure à la valeur prescrite de la tension inteme d'alimentation de la mémoire à semiconducteur et pour laquelle la mémoire fonctionne juste encore conformément à sa fonction,
- on règle la tension interne d'alimentation à la valeur de la tension élevée, **caractérisé en ce que** l'on utilise comme paramètre caractérisant le temps d'accès le courant de stand-by de la mémoire à semiconducteur.

2. Procédé pour minimiser le temps d'accès à des données d'une mémoire à semiconducteur au moyen d'un générateur de tension d'alimentation servant à produire une tension inteme d'alimentation, qui est réalisée par les étapes opératoires suivantes :
- en fonction d'une valeur donnée de la tension interne d'alimentation, on détermine la valeur d'un paramètre caractérisant le temps d'accès,
- on associe à la valeur déterminée du paramètre la valeur d'une tension plus élevée, qui est en valeur absolue supérieure à la valeur donnée de la tension interne d'alimentation de la mémoire à semiconducteur et pour laquelle la mémoire travaille juste encore conformément à sa fonction,
- on règle la tension interne d'alimentation à la valeur de la tension plus élevée, **caractérisé en ce que** l'on utilise comme paramètre caractérisant le temps d'accès, la tension de passage à l'état passant d'un transistor à effet de champ se trouvant sur la mémoire à semiconducteur.

3. Procédé suivant l'une des revendications 1 ou 2, **caractérisé en ce que** l'on détermine la valeur du paramètre caractérisant le temps d'accès après application d'une tension exteme d'alimentation à la mémoire à semiconducteur dès que la mémoire à semiconducteur a atteint son état prêt à fonctionner.

4. Procédé suivant l'une des revendications 1 ou 2, **caractérisé en ce que** l'on détermine la valeur du paramètre caractérisant le temps d'accès pendant un test fonctionnel de la mémoire à semiconducteur.

5. Procédé suivant l'une des revendications 1 ou 2, **caractérisé en ce que** l'association de la valeur de la tension plus élevée à la valeur du paramètre déterminée s'effectue au moyen de courbes de mesure déterminées expérimentalement.

6. Procédé suivant l'une des revendications 1 ou 2, **caractérisé en ce que** le réglage de la tension interne d'alimentation à la valeur de la tension élevée s'effectue en détachant au moins un fusible du générateur de tension d'alimentation.

7. Procédé suivant la revendication 2, **caractérisé en ce que** le réglage de la tension interne d'alimentation à la valeur de la tension plus élevée s'effectue en commandant le générateur de tension d'alimentation au moyen d'un circuit de commande auquel la tension de passage à l'état passant du transistor à effet de champ est transmise.

8. Procédé suivant la revendication 6, **caractérisé en ce que** le détachement des fusibles s'effectue parallèlement dans le temps au détachement d'autres éventuels fusibles de la mémoire à semiconducteur.

9. Procédé suivant l'une des revendications 1 ou 2, **caractérisé en ce que** le réglage de la tension interne d'alimentation à la valeur de la tension plus élevée s'effectue par paliers.

10. Procédé suivant la revendication 9, **caractérisé en ce que** le réglage s'effectue en paliers de 0,3 V.
